# EUROPEAN PATENT APPLICATION

(11) **EP 2 468 403 A1**
(43) Date of publication of application: **27.06.2012**
(21) Application number: 10196094.6
(22) Date of filing: 21.12.2010
(51) Int. Cl.: B01L 3/00, B81C 1/00

(54) **A method for manufacturing a microfluidic device**

(71) Applicant: Koninklijke Philips Electronics N.V., 5621 BA Eindhoven (NL)
(72) Inventor: The designation of the inventor has not yet been filed
(74) Representative: Volmer, Georg

(57) **Abstract**

The invention relates to a method for manufacturing a microfluidic device (200) comprising the steps of producing a first plastic component (210) with a microfluidic cavity (211), of depositing a metal layer (221) on a second plastic component (222), and of structuring said metal layer by laser ablation. The first and the second plastic component may be identical. If they are different parts, they are joined to each other, for example by in-mold assembly, by gluing, or by thermal welding.

## Description

### FIELD OF THE INVENTION

The invention relates to a microfluidic device comprising metal structures and to a method for manufacturing such a device.

### BACKGROUND OF THE INVENTION

From the US 2005/130292 Al, a microfluidic device is known that comprises microfluidic channels and electrical lines which constitute a heater.

### SUMMARY OF THE INVENTION

Based on this background, it was an object of the present invention to provide alternative means that allow for a cost-effective mass production of microfluidic devices with electrical or electronic components.

This object is achieved by a method according to claim 1 and a microfluidic device according to claim 2. Preferred embodiments are disclosed in the dependent claims.

The method according to the present invention serves for manufacturing a "microfluidic device", i.e. a device with cavities (channels, chambers, inlets, outlets etc.) that can accommodate and/or transport a fluid and that have small characteristic dimensions (typically smaller than 1 mm). The method comprises the following steps, which can be executed in the listed or any other appropriate order:
a) Production of a first plastic component comprising at least one microfluidic cavity (e.g. a channel, chamber etc.).
b) Depositing a metal layer on a second plastic component, wherein this second plastic component may be identical to the first plastic component or may be a different part. Preferably, the deposited metal layer is a single, homogenous layer.
c) Structuring the aforementioned metal layer by laser ablation. This means that the metal layer is locally completely removed, leaving structures behind that are electrically isolated from each other.
d) Joining the first plastic component to the second plastic component with the structured metal layer if these two components are different from each other. If the first and the second plastic component are identical, such a joining step is of course superfluous.

The described method allows to produce microfluidic devices cost-effectively in large numbers because it can be realized in a highly automated manner. In particular, the structuring of the metal layer by laser ablation is a flexible procedure in which (new) data coming from a CAD model can automatically be processed without a need for elaborate hardware changes.

The invention further comprises a microfluidic device with the following components:
a) A first plastic component comprising at least one microfluidic cavity.
b) A single structured metal layer on a second plastic component,
wherein said layer is obtained from a single, initially continuous metal layer by structuring, particularly by laser ablation.

Moreover, the first plastic component and the second plastic component are either identical or joined to each other. The microfluidic device may for instance be manufactured by the method described above.

In the following, various preferred embodiments of the invention will be described that relate to both the manufacturing method and the microfluidic device.

The first plastic component comprising the at least one microfluidic cavity can cost effectively be produced in large numbers by injection molding.

The thickness of the first plastic component may typically range between about 10 µm and about 10 mm, depending on the application the microfluidic device is intended for.

The metal layer may preferably comprise a metal selected from the group consisting of gold (Au), aluminum (A1), copper (Cu), platinum (Pt), and silver (Ag).

The thickness of the metal layer preferably ranges between about 10 nm and about 1000 nm.

In general, the metal layer may be deposited on the second plastic component by any appropriate method. Preferably, it may be deposited by sputtering, by electrochemical plating, by (screen) printing, or by vapor deposition.

If the second plastic component is different from the first plastic component, it may for example be a foil or a plate. The thickness of the second plastic component (without metal layer) may preferably range between about 10 µm and about 1000 µm Using thin plates or foils as the second plastic component has the advantage that three-dimensional shapes can readily be produced by bending the component accordingly.

The first plastic component and/or the second plastic component preferably comprise a material that is selected from the group consisting of polyethylene terephthalate (PET), polystyrene (PS), polycarbonate (PC), cyclic-olefin polymer (COP), cyclic-olefin co-polymer (COC), polymethyl methacrylate (PMMA), liquid crystalline polymer (LCP), polypropylene (PP), polyethylene (PE), polyamide (PA), and acrylonitrile butadiene styrene (ABS).

There is a variety of possibilities how the first plastic component and the second plastic component - if they are different - can be joined. According to one preferred realization, the second plastic component with the structured metal layer is joined to the first plastic component by an in-mold assembly. This means that the accomplished second plastic component (i.e. with a structured metal layer) is put into the mold in which the first plastic component is then produced by injection molding. This approach has the advantage that two steps of the manufacturing procedure (steps a) and d)) can be integrated into one single step.

According to another embodiment of the invention, the second plastic component with the structured metal layer is joined to the first plastic component by gluing or by thermal welding.

As already mentioned above, the second plastic component with the structured metal layer may preferably be bent into a non-planar, three-dimensional shape when it is joined to the first plastic component.

In general, a large variety of electrical or electronic components can be realized by structuring the metal layer on the second plastic component, for example sensors or actuators. In a preferred embodiment, the metal layer is structured to comprise at least one heater and/or at least one heat sensor. A heater can be produced by providing electrically conductive lines with a sufficiently high resistance, for example by producing lines with a small width or height. A heat sensor can similarly be produced as a conductor with a resistance that is temperature dependent.

The aforementioned heater and the at least one heat sensor may preferably be arranged adjacent to each other and adjacent to a microfluidic cavity such that they provide a flow sensor. Such a flow sensor may use the principle that heat produced by the heater is spatially distributed by convection depending on the flow of a fluid in the adjacent cavity. Measuring the temperature at one or (preferably) more locations will therefore allow to infer the direction and/or magnitude of the fluid flow.

The invention further comprises a microfluidic device as it can be (or is) produced by one of the described methods. Such a microfluidic device therefore comprises a (second) plastic component with a structured metal layer that is integrated with or joined to a (first) plastic component with a microfluidic cavity.

### BRIEF DESCRIPTION OF THE DRAWINGS

These and other aspects of the invention will be apparent from and elucidated with reference to the embodiment(s) described hereinafter. These embodiments will be described by way of example with the help of the accompanying drawings in which:
Figure 1 schematically shows a sensor architecture comprising a disposable microfluidic device and a reusable reader;
Figure 2 shows a top view onto a ("second") plastic component with a structured metal layer on top;
Figure 3 shows a top view onto the aforementioned plastic component after it has been joined with a ("first") plastic component comprising microfluidic cavities;
Figures 4 and 5 are photos of heaters and heat sensors produced in a 30 nm gold layer on PET foil by laser ablation;
Figure 6 shows schematically a side view of a microfluidic device with a flow sensor comprising a heater and two heat sensors;
Figures 7 and 8 show resistances measured with the heat sensors of the microfluidic device of Figure 6 located downstream (Figure 7) and upstream (Figure 8), respectively;
Figures 9 and 10 show the difference of the upstream and downstream resistances of the heat sensors for various flow rates.

Like reference numbers or numbers differing by integer multiples of 100 refer in the Figures to identical or similar components.

### DESCRIPTION OF PREFERRED EMBODIMENTS

Microfluidic devices for use in in-vitro diagnostics (IVD) are often disposable to prevent cross contamination when examining samples of multiple patients. Because of their single use, these disposables have to be manufactured at low unit costs. Sensors and actuators could improve the quality of the fluidic processes inside such microfluidic devices and indirectly could positively affect the bio-chemical process. However, sensors and actuators should be compatible for use in microfluidic channels having sub-millimeter dimensions typically created in plastics.

Micro-electronic sensors and actuators can be created in silicon using photolithographic structuring methods or on glass using techniques as used in creation of LCD screens. The unit costs of such sensors typically range between about 10 and 100 Euro. The sensor or actuator of such devices should be in contact with the fluid flow inside the microfluidic channels. This poses considerable challenges with respect to micro-scale integration and sealing against fluid leakage. Since plastic microfluidic devices for IVD application are typically produced at 10⁶ parts/year, the assembly process of sensors and actuators with the microfluidic parts should allow for mass manufacturability.

In view of the above issues, the following measures are proposed:
- Physical split-up of a sensor/actuator embodiment into a disposable and a re-usable part.
- Application of a thin and continuous single metal layer on a ("second") plastic substrate for creation of a disposable micro-electronic structure.
- Electrical circuits of micro sensors and actuators are realized by isolating them from their surroundings via laser ablation.

Integration of the (disposable part of) sensors and actuators with the microfluidic circuit ("first plastic component") can be performed by one of the following techniques:
- Creation of micro-electronic layout on a plastic foil and assembly with an injection molded first plastic component via in-mold assembly.
- Application of the continuous metal layer directly in the microfluidic circuit, after injection molding of a microfluidic part (first plastic component), and subsequent laser ablation.
- Creation of a micro-electronic layout on plastic foil or on a flat part and subsequent joining this with a plastic part displaying a microfluidic circuit ("first plastic component") using either gluing or thermal welding.

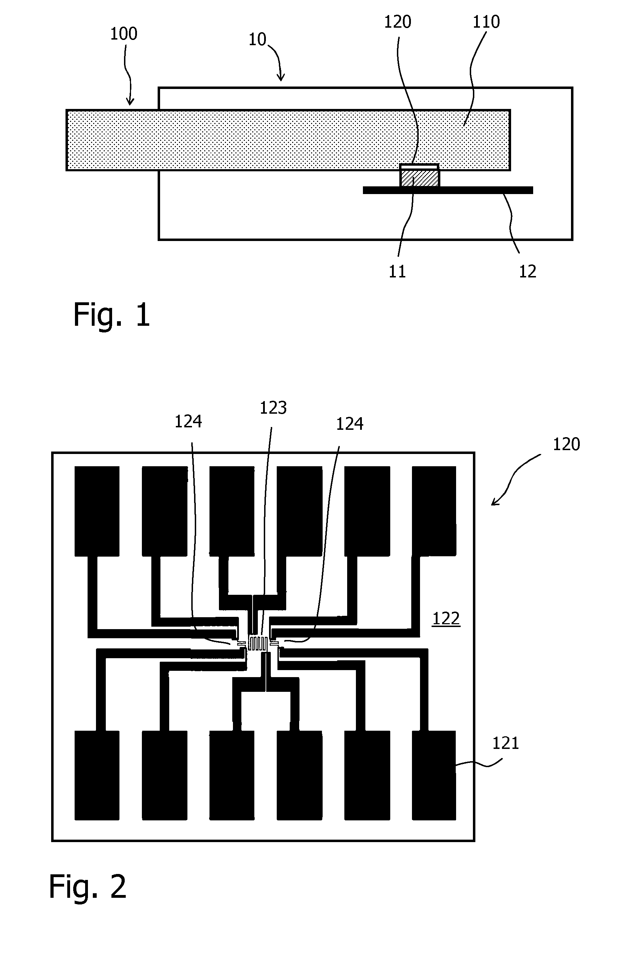

Figure 1 schematically shows a side view of a sensor architecture for screening of drugs-of-abuse comprising an electronic analyzer 10 which can process a sample provided in a disposable IVD cartridge 100. The electronic analyzer 10 comprises a PCB board 12 with a sensor driver, a controller etc. that carries a sensor interface 11. All components of the electronic analyzer 10 are reusable. In contrast to this, the whole IVD cartridge 100 is disposable. It comprises a first plastic component 110 with micro fluidic cavities (not shown) and a disposable sensor located in a second plastic component 120.

The sensor architecture of Figure 1 realizes a split of a micro-electronic sensor into a disposable part 100 and a reusable part 10. Many in-vitro diagnostic products consist of an electronic analyzer in combination with disposable cartridges and are therefore apt for such a split design.

The manufacturing of a disposable micro fluidic device with electrical components, like the cartridge 100, will in the following be described with respect to an exemplary micro flow sensor. The flow sensor is based on the principle of providing heat using a centrally placed (resistive) heating element and measuring the difference in temperature on both sides of the heater resulting from convective heat transport by a fluid.

Figure 2 shows a top view onto a plastic component 122 (referred to as "second plastic component" in this application) with a structured metal layer 121 on top. The metal layer 121 comprises a centrally placed resistive heater 123 with temperature sensing elements 124 on both sides. Temperature sensing in the heat sensors 124 is based on variation in electrical resistance due to variation in temperature.

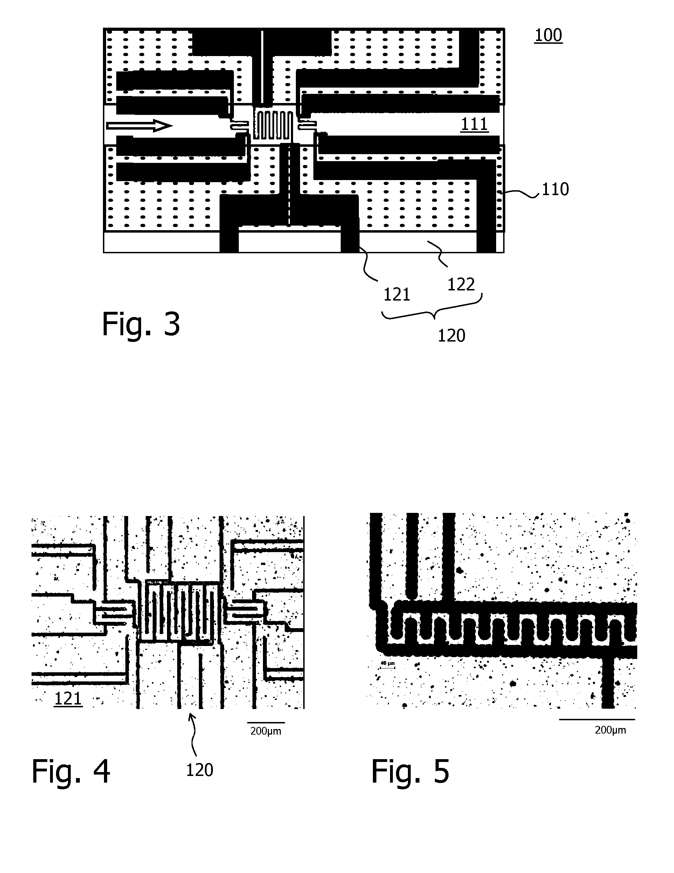

Figure 3 shows a top view onto the aforementioned second plastic component 122 with the structured metal layer 121 after it has been joined with a "first plastic component" 110 comprising microfluidic cavities, particularly a flow channel 111. When a fluid flows along this channel 111 from left to right in the direction of the arrow, heat generated by the central heater will be transported to the right by convection, yielding a higher temperature at the right sensor than at the left.

The micro electrical circuit of the flow sensor is realized in a single metal layer 121 on a plastic substrate 122. Therefore, heating and sensing elements are all made from the same metal, e.g. gold (Au). Initially, the gold is a continuous layer on the plastic substrate 122. This layer can be applied to the substrate either by sputtering, electrochemical plating, (screen) printing, or vapor deposition techniques. The actual layout of the flow sensor is realized by "isolating" the electrical circuit from its surroundings via laser ablation.

Figures 4 and 5 show the result of the aforementioned procedure when the flow sensor is realized in a 30 nm gold layer 121 on a 20 micron thick PET plastic foil.

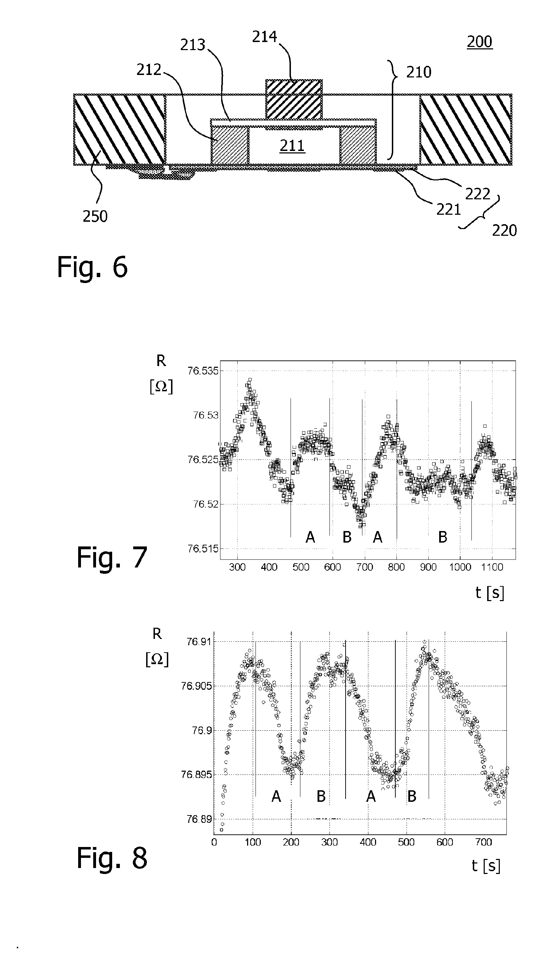

Feasibility of the sensor functionality was demonstrated with a proto-type shown in Figure 6 in a schematic side view. This microfluidic device 200 comprises a 20 µm PET foil 222 ("second plastic component") with a laser-structured 30 nm Au layer 221 on top that constitutes a flow sensor. The foil 222 is stretched over a hole, cut out of a printed circuit board (PCB) 250 to monitor the thermal fluidic behavior of the sensor with an IR camera (not shown). The electrical connections from the PCB 250 to the metal layer 221 are made using electrically conducting wires that were soldered to the PCB 250 and connected using an electrically conducting adhesive to the Au layer 221. The foil 222 is joined with a plastic transparent substrate 213 providing the fluidic interconnection 214 using a patterned double-sided tape 212 to define the dimensions of the fluidic channel 211.

The described thermal flow sensor is located at the side-wall of the channel 211 and is used for liquid flow sensing. Figures 7 and 8 show the resistance R as a function of time t for a flow rate of 2.5 µL/min, wherein letters "A" indicate times during which flow was "on", while letters "B" indicate times during which flow was "off". The sensing element at the downstream location (Figure 7) displays an increase in resistance in case liquid flow is applied (A). This is the result of increase in temperature due to convective heat transport from the heater located upstream. Contrary, the sensing element located upstream of the heater (Figure 8) displays a decrease in resistance during flow (A) due to cooling.

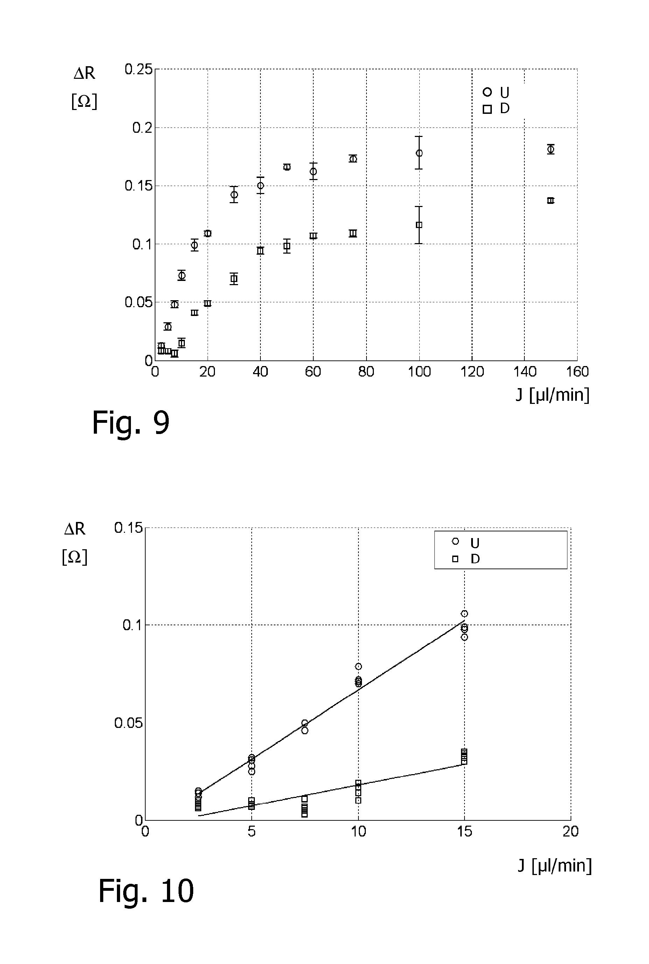

Figure 9 shows the absolute values of changes ΔR in resistance resulting from flow/no-flow situations (U = upstream sensor, D = downstream sensor). Dependent on applied liquid flow rate J, changes in resistance ranging from 8-180 mΩ are observed for a constant heater power (i.e. I_{H} = 1 mA). The enlarged diagram of Figure 10 shows that the flow sensor has a linear operating mode for flow rates up to about 15 µL/min.

In summary, the present invention focuses on system architecture of sensors by splitting the physical embodiment of a sensor into a re-usable and a disposable part. It proposes the creation of the low cost disposable part of micro electronic sensors and actuators for use in plastic micro fluidic devices by structuring a thin and (initially) continuous or coarsely defined metal layer on a plastic substrate using laser ablation.

The metal layer can be applied on a plastic substrate using sputtering, (screen) printing, electrochemical plating, or vapor deposition. The metal layer is initially a continuous layer or a metal layer with a coarsely defined outer contour. Using laser ablation, a structured micro-electronic circuit can be electrically isolated from its surroundings and/or final electrical layout can be fine tuned. The plastic substrate can be an injection molded part with a microstructured surface displaying a micro fluidic circuit. In this way the sensor or actuator is integrated with the microfluidic circuit and is created in-situ. Another possibility is to create the sensor or actuator on a thin plastic flexible foil. The plastic foil could be glued or thermally welded onto a plastic counter part, in this way creating a closed microfluidic channel. Alternatively, the flexible foil with micro-electronic circuit could be bend to follow the inner/outer contours of a (microfluidic) device or the inner diameter of a device used in minimally invasive surgery such as a catheter or endoscope. The materials and the production methods used to realize the micro-electronic sensors and actuators result in significant advantages for use in (disposable) plastic microfluidic devices. As an example a micro flow sensor with overall dimensions in the order of several square millimeters has been realized on a thin plastic substrate, i.e. on a 20 micron thick PET foil.

The advantages provided by the present invention are:
- Low unit costs due to low manufacturing and low material costs.
- Ability to manufacture in high volumes with a high degree of automation, using injection molding process as an integration platform.
- Laser ablation is a highly automated process suitable for mass manufacturing to create complex shaped features. It can directly transfer an electronic CAD model (e.g. DXF file format) into the metal layer and is therefore highly flexible in design.
- Realization in thin foils requires little design space and provides flexibility to follow contours. Thin foils can e.g. follow contours of bended surfaces or sensors can be created on (curved) surface of injection molded parts.
- Realization is based on plastic substrates enabling easy integration into plastic based microfluidic circuits:
- either the metal layer can be applied after the microfluidic circuit has already been formed; The sensor is created in-situ by laser ablation resulting in excellent positioning of sensor with respect to fluidic circuit.
- or easy joining of plastic substrate using thermal welding techniques to avoid fluid leakage;
- or by using the injection molding process as integration platform, i.e. in-mold assembly.
- Integration of micro sensors and actuators with plastic based microfluidic circuit such that fluid tight channels result displaying little dead volume.

The present invention can be applied for flow sensing in the range of nanoliter/min - microliters/min in microfluidic channels. Moreover, microfluidic channels can be part of larger devices with use in various applications:
- nebulizers for treating asthmatic diseases having microfluidic channels for medicine and/or air flow to generate aerosols;
- medical devices for treating sleeping disorder, i.e. apnoea; control of pressurized air flow with controlled humidity supplied to patient;
- microfluidic fuel cells enabling hand held power supply to electronic devices; such cells may either be based on direct methanol (DMFC) and a flow sensor to control flow of liquid fuel or fuel cells based on solid oxyte (SOFC) where a flow sensor is used to control flow of gaseous fuel and air ;
- disposable microfluidic cartridges, i.e. lab-on-chip devices, for use in (hand held) IVD applications; flow sensing of physiological liquids and/or liquid reagents;
- (disposable) medical devices used in minimally invasive surgery or for image guided intervention, i.e. endoscopic devices or catheters.

Finally it is pointed out that in the present application the term "comprising" does not exclude other elements or steps, that "a" or "an" does not exclude a plurality, and that a single processor or other unit may fulfill the functions of several means. The invention resides in each and every novel characteristic feature and each and every combination of characteristic features. Moreover, reference signs in the claims shall not be construed as limiting their scope.

## Claims

1. A method for manufacturing a micro fluidic device (100, 200), said method comprising the following steps:
a) producing a first plastic component (110, 210) comprising at least one microfluidic cavity (111, 211);
b) depositing a metal layer (121, 221) on a second plastic component (122, 222);
c) structuring said metal layer (121, 221) by laser ablation;
d) joining the first plastic component (110, 210) to the second plastic component (122, 222) with the structured metal layer (121, 221) if these components are different from each other.

2. A microfluidic device (100, 200) comprising:
a) a first plastic component (110, 210) comprising at least one micro fluidic cavity (111, 211);
b) a single structured metal layer (121, 221) on a second plastic component (122, 222), wherein said layer is obtained from an initially continuous metal layer by structuring;
wherein the first plastic component (110, 210) and the second plastic component (122, 222) are joined or identical.

3. The method according to claim 1 or the micro fluidic device (100, 200) according to claim 2,
**characterized in that** the first plastic component (110, 210) is produced by injection molding.

4. The method according to claim 1 or the micro fluidic device (100, 200) according to claim 2,
**characterized in that** the first plastic component (110, 210) has a thickness between about 10 µm and about 1000 µm.

5. The method according to claim 1 or the micro fluidic device (100, 200) according to claim 2,
**characterized in that** the metal layer (121, 221) comprises a metal selected from the group consisting of gold (Au), aluminum (Al), copper (Cu), silver (Ag), and platinum (Pt).

6. The method according to claim 1 or the micro fluidic device (100, 200) according to claim 2,
**characterized in that** the metal layer (121, 221) has a thickness between about 10 nm and about 1000 nm.

7. The method according to claim 1 or the micro fluidic device (100, 200) according to claim 2,
**characterized in that** the metal layer (121, 221) is deposited by sputtering, electrochemical plating, printing, screen printing, or vapor deposition.

8. The method according to claim 1 or the micro fluidic device (100, 200) according to claim 2,
**characterized in that** the second plastic component is a foil (122, 222) or a plate.

9. The method according to claim 1 or the micro fluidic device (100, 200) according to claim 2,
**characterized in that** the second plastic component (122, 222) has a thickness between about 1 µm and about 1000 µm

10. The method according to claim 1 or the micro fluidic device (100, 200) according to claim 2,
**characterized in that** the first plastic component (110, 210) or the second plastic component (122, 222) comprises a material selected from the group consisting of PET, polyethylene terephthalate (PET), polystyrene (PS), polycarbonate (PC), cyclic-olefin polymer (COP), cyclic-olefin co-polymer (COC), polymethyl methacrylate (PMMA), liquid crystalline polymer (LCP), polypropylene (PP), polyethylene (PE), polyamide (PA), and acrylonitrile butadiene styrene (ABS).

11. The method according to claim 1 or the microfluidic device (100, 200) according to claim 2,
**characterized in that** the second plastic component (122, 222) with the structured metal layer (121, 221) is joined to the first plastic component (110, 210) by in-mold assembly, by gluing, or by thermal welding.

12. The method according to claim 1 or the micro fluidic device (100, 200) according to claim 2,
**characterized in that** the second plastic component (122, 222) with the structured metal layer (121, 221) is bent when being joined to the first plastic component (110, 210).

13. The method according to claim 1 or the micro fluidic device (100, 200) according to claim 2,
**characterized in that** the metal layer (121, 221) is structured to comprise a heater (123) and/or at least one heat sensor (124).

14. The method according to claim 13 or the microfluidic device (100, 200) according to claim 2,
**characterized in that** the heater (123) and the heat sensor (124) are arranged adjacent to each other and adjacent to the microfluidic cavity (111) to provide a flow sensor.

15. A micro fluidic device (100, 200) that is produced by a method according to any of claims 1 to 14.
